# EUROPEAN PATENT APPLICATION

(11) **EP 1 895 372 A2**
(43) Date of publication of application: **05.03.2008**
(21) Application number: 07108929.6
(22) Date of filing: 25.05.2007
(51) Int. Cl.: G04F 5/14

(54) **Microcontainer for hermetically encapsulating reactive materials**

(30) Priority: 30.08.2006 US 468527
(71) Applicant: HONEYWELL INC., Morristown, New Jersey 07962 (US)
(72) Inventor: Youngner, Dan W., Maple Grove, MN 55311 (US); Lu, Son T., Plymouth, MN 55447 (US); Stark, Terry D., Golden Valley, MN 55427 (US); Chanhvongsak, Elenita M., Lakeville, MN 55044 (US)
(74) Representative: Haley, Stephen

(57) **Abstract**

A microcontainer device for micro-electro-mechanical systems such as atomic clocks is provided. The microcontainer device includes a substrate and a cavity in the substrate defined by a sidewall having an upper edge. The cavity is configured to hold a reactive material such as rubidium or cesium. A lid having a lower surface is configured to sealingly cover the cavity. A first hermetic material is disposed around an outer perimeter of the upper edge of the sidewall, and a second hermetic material is disposed around a perimeter of the lower surface of the lid. A sealing material chemically compatible with the reactive material is disposed around an inner perimeter of the upper edge of the sidewall adjacent to the first hermetic material.

## Description

The U.S. Government may have certain rights in the present invention as provided for by the terms of Contract No. N66001-02-C-8019 with DARPA / Navy SPAWAR.

Micro-electro-mechanical systems (MEMS) is the integration of mechanical elements, sensors, actuators, and electronics on a common semiconductor substrate through microfabrication technology. While the electronics are fabricated using integrated circuit (IC) processes, the micromechanical components are fabricated using compatible micromachining processes that selectively etch away parts of the substrate such as a silicon wafer or add new structural layers to form mechanical and electromechanical devices.

MEMS devices include a variety of chip-scale (micron) or nano-scale devices such as switches, sensors, gyroscopes, accelerometers, atomic clocks, etc. Due to the small scale of these devices and their components, manufacturing processes are required that allow for the production of small scale features, without contaminating or altering the desired chemical makeup of the components of the devices.

MEMS devices provide highly precise and accurate measurement capabilities. For example, an atomic clock can be used in various systems that require extremely accurate and stable frequencies, such as in bistatic radars, global positioning systems, and other navigation and positioning systems, as well as in wireless communications.

One type of atomic clock known as a cell type atomic clock operates by simultaneously irradiating an active medium with optical power and microwave power. The optical power pumps the atoms of the active medium, usually rubidium or cesium, to make the medium absorbing at the microwave frequency corresponding to transitions between the two hyperfine levels of the ground state. It is desirable to have the longest amount of time possible to measure the energy levels (*i.e.,* frequency) of such atoms. One way to obtain a long measurement time is to keep the atoms in one place while measuring them. This can be done by containing the atoms in a cavity or cell, for example. Generally, such cell structures provide a vacuum environment where the active medium can be controllably provided as a vapor.

Previous attempts to make chip-scale atomic clocks have used anodic (i.e., thermo-electric) bonding or glass bonding to seal the cavity or cell containing the active medium. Neither of these processes, however, works well with most MEMS structures.

The present invention is related to a microcontainer device that can be used in micro-electro-mechanical systems. The microcontainer device comprises a substrate and a cavity in the substrate that is defined by a sidewall having an upper edge. The cavity is configured to hold a reactive material. A first hermetic material is disposed around an outer perimeter of the upper edge. A sealing material chemically compatible with the reactive material is disposed around an inner perimeter of the upper edge adjacent to the first hermetic material. A lid having a lower surface is configured to sealingly cover the cavity. A second hermetic material is disposed around a perimeter of the lower surface of the lid.

### IN THE DRAWINGS

Features of the present invention will become apparent to those skilled in the art from the following description with reference to the drawings. Understanding that the drawings depict only typical embodiments of the invention and are not therefore to be considered limiting in scope, the invention will be described with additional specificity and detail through the use of the accompanying drawings, in which:

Figure 1 is a schematic perspective view of a microcontainer for a reactive material used in a MEMS device; and

Figure 2 is a top view of a microcontainer for a reactive material that can be used in an atomic clock.

In the following detailed description, embodiments are described in sufficient detail to enable those skilled in the art to practice the invention. It is to be understood that other embodiments may be utilized without departing from the scope of the present invention. The following detailed description is, therefore, not to be taken in a limiting sense.

When building chip-scale devices such as atomic clocks, it is necessary to hermetically encapsulate reactive materials inside enclosures such as microcontainers. The present invention provides a technique for doing so in a MEMS-compatible manner. Generally, a solder material is used to seal the enclosure, and an organic material is used to provide a chemically compatible interface. The solder material provides good hermeticity but may lack adequate chemical compatibility with the reactive material inside the cavity of the enclosure. The organic material is chemically compatible with the reactive material but may lack adequate hermeticity. Thus, the present configuration of sealing materials simultaneously achieves chemical compatibility and hermeticity in an enclosure such as a microcontainer.

The various reactive and sealing materials utilized in the present invention can be deposited onto a surface by conventional deposition techniques. Nonlimiting examples of such deposition techniques include physical vapor deposition (PVD), chemical vapor deposition (CVD), plasma enhanced (PE) variations thereof such as PECVD, sputtering, electrolysis deposition, and the like. Such deposition processes normally take place in a vacuum, which provides a clean environment for processing and depositing the materials, thereby minimizing contamination and/or undesirable reaction. Vacuum deposition methods cause material to be evaporated at a high temperature and deposited onto a surface at a lower temperature.

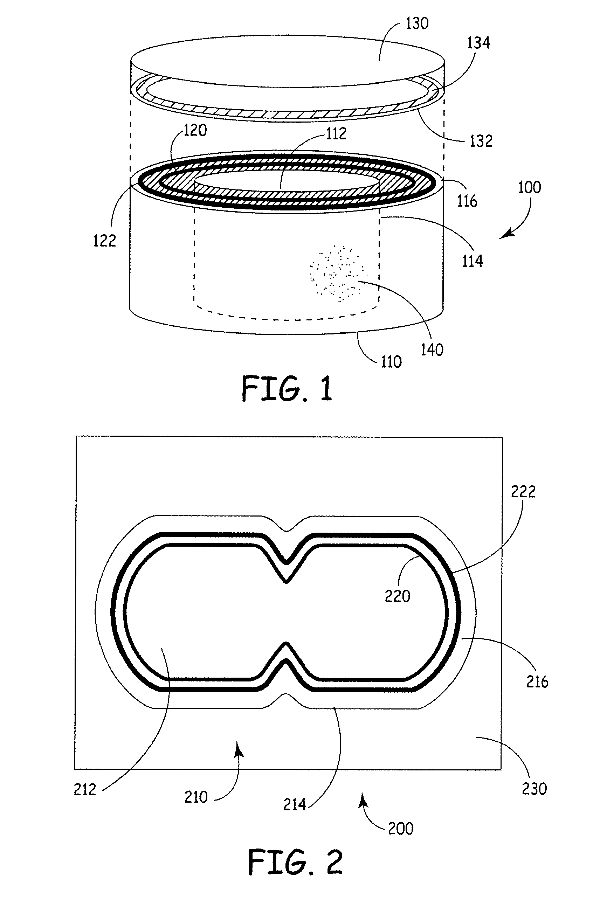

Figure 1 is a schematic perspective view of one embodiment of a microcontainer 100 for enclosing a reactive material, which can be used in a MEMS device such as an atomic clock. The microcontainer 100 is formed on a substrate 110, which may be any useful substrate for preparing MEMS devices such as atomic clocks. An exemplary substrate is a semiconductor substrate such as a silicon wafer. A cavity 112 is formed in substrate 110 and is defined by a sidewall 114 of substrate 110 having an upper edge 116. The cavity 112 can be formed by conventional methods of processing microelectronic or semiconductor substrates, such as by etching, photolithography, laser drilling, electroplating, and the like.

A sealing material 120 is disposed around an inner perimeter of upper edge 116. The sealing material 120 is chemically compatible with the reactive material that is placed in microcontainer 100. For example, sealing material 120 can be an organic material such as a photoresist epoxy resin. A suitable epoxy resin is SU-8 epoxy resin, which is a fully epoxidized bisphenol-A/formaldehyde novolac copolymer. This epoxy resin has an average epoxide group functionality of about eight.

A first hermetic material 122 is formed around an outer perimeter of upper edge 116 so that hermetic material 122 is concentric with sealing material 120. The first hermetic material 122 can be a solder material such as a tin-lead solder material.

The microcontainer 100 also has a lid 130 having a lower surface 132 that is configured to sealingly cover cavity 112. The lid 130 can be formed of the same material as substrate 110 such as a semiconductor material. The lid 130 can be formed by conventional semiconductor fabrication techniques.

The lid 130 is configured to protect the reactive material from unwanted exposure to water, air, or wet processing chemicals. A second hermetic material 134 is disposed around a perimeter of lower surface 132 of lid 130. The second hermetic material 134 can include gold, nickel, or layers or alloys thereof. For example, hermetic material 134 can include a first layer of nickel over lower surface 134, and a second layer of gold over the first layer of nickel.

A reactive material 140 is disposed in cavity 112 prior to attaching lid 130 on upper edge 116. The reactive material can include, for example, rubidium or cesium. The reactive material 140 can be deposited into cavity 112 by conventional vapor deposition techniques.

Figure 2 is a top view of another embodiment of a microcontainer 200 for enclosing a reactive material, which can be used in a MEMS device such as an atomic clock. The microcontainer 200 is formed on a substrate 210 such as a semiconductor substrate. A cavity 212 is formed in substrate 210 and is defined by a sidewall 214 having an upper edge 216. The cavity 212 can be formed by conventional processing methods such as discussed above for cavity 112 (Figure 1).

A sealing material 220 is disposed around an inner perimeter of upper edge 216. The sealing material is chemically compatible with the reactive material that is placed in microcontainer 200. For example, sealing material 220 can be an organic material such as a photoresist epoxy resin. A suitable epoxy resin is SU-8 epoxy resin. A first hermetic material 222 is formed around an outer perimeter of upper edge 216 so that hermetic material 222 is concentric with sealing material 220. The first hermetic material 222 can be a solder material such as a tin-lead solder material. Additional solder material can be deposited on substrate 210 in a field area 230 outside of sidewall 214 to provide enhanced mechanical strength to microcontainer 200.

A lid (not shown), similar to lid 130 described previously, may also be provided to sealingly cover cavity 212 of microcontainer 200. A second hermetic material, such as that described with respect to lid 130, can be disposed around a perimeter of a lower surface of the lid for microcontainer 200.

In a method of fabricating a microcontainer device of the invention for a MEMS device such as an atomic clock, a suitable substrate is provided and a cavity is formed in the substrate such that the cavity is defined by a sidewall having an upper edge. A first hermetic material is deposited around an outer perimeter of the upper edge, and a sealing material is deposited around an inner perimeter of the upper edge, with the sealing material being chemically compatible with a reactive material. A sealing lid is provided, and a second hermetic material is deposited around a perimeter of the lower surface of the lid. A reactive material is then deposited in the cavity. The lid is placed over the cavity so that the first hermetic material is aligned with the second hermetic material, and the lid is hermetically sealed on the upper edge of the sidewall defining the cavity.

The present invention may be embodied in other specific forms without departing from its essential characteristics. The described embodiments are to be considered in all respects only as illustrative and not restrictive. The scope of the invention is therefore indicated by the appended claims rather than by the foregoing description. All changes that come within the meaning and range of equivalency of the claims are to be embraced within their scope.

## Claims

1. A microcontainer device comprising:
a substrate;
a cavity in the substrate and defined by a sidewall having an upper edge, the cavity configured to hold a reactive material;
a first hermetic material disposed around an outer perimeter of the upper edge;
a sealing material chemically compatible with the reactive material and disposed around an inner perimeter of the upper edge adjacent to the first hermetic material;
a lid having a lower surface that is configured to sealingly cover the cavity; and
a second hermetic material disposed around a perimeter of the lower surface of the lid.

2. The microcontainer device of claim 1, wherein the substrate comprises a semiconductor material.

3. The microcontainer device of claim 1, wherein the reactive material comprises rubidium or cesium.

4. The microcontainer device of claim 1, wherein the first hermetic material comprises a solder material.

5. The microcontainer device of claim 4, wherein the solder material comprises a tin-lead solder material.

6. The microcontainer device of claim 1, wherein the second hermetic material comprises a first layer of nickel over the lower surface of the lid, and a second layer of gold over the first layer.

7. The microcontainer device of claim 1, wherein the sealing material comprises a photoresist epoxy resin.

8. The microcontainer device of claim 7, wherein the photoresist epoxy resin comprises a fully epoxidized bisphenol-A/formaldehyde novolac copolymer.

9. The microcontainer device of claim 8, wherein the photoresist epoxy resin has an average epoxide group functionality of about eight.

10. An atomic clock device comprising the microcontainer device of claim 1.
